# EUROPÄISCHE PATENTSCHRIFT

(11) **EP 2 702 405 B1**
(45) Veröffentlichungstag und Bekanntmachung des Hinweises auf die Patenterteilung: **25.03.2015**
(21) Anmeldenummer: 12719639.2
(22) Anmeldetag: 26.04.2012
(51) Int. Cl.: G01N 33/49, G01N 27/327

(54) **SENSORELEMENT MIT EINER TA ODER NB ENTHALTENDEN GRUNDSCHICHT, UND VERFAHREN ZU DESSEN HERSTELLUNG**
SENSOR ELEMENT WITH A TA OR NB CONTAINING BASE LAYER, AND METHOD FOR THE PRODUCTION THEREOF
ELÉMENT CAPTEUR COMPORTANT UNE COUCHE DE BASE CONTENANT DU TA OU DU NB, ET SON PROCÉDÉ DE FABRICATION

(30) Priorität: 29.04.2011 EP 11164256
(43) Veröffentlichungstag der Anmeldung: 05.03.2014
(73) Patentinhaber: Roche Diagnostics GmbH, 68305 Mannheim (DE); F.Hoffmann-La Roche AG, 4070 Basel (CH)
(72) Erfinder: HARTTIG, Herbert, 67434 Neustadt (DE)
(74) Vertreter: Pfiz, Thomas
(86) Internationale Anmeldenummer: PCT/EP2012/057702
(87) Internationale Veröffentlichungsnummer: WO 2012/146684

(56) Entgegenhaltungen:
- WO-A1-2009/056299
- WO-A2-2006/018447
- US-A1- 2005 019 212
- US-A1- 2009 297 913
- US-A1- 2010 101 965

## Beschreibung

Die Erfindung betrifft ein Sensorelement zur elektrochemischen Untersuchung einer Probe, insbesondere einer Körperflüssigkeit, mit einem elektrisch isolierenden Trägersubstrat und einer auf der Substratoberfläche aufgebrachten, elektrisch leitenden Schichtstruktur, die eine mit der Probe beaufschlagbare Elektrodenanordnung besitzt. Die Erfindung betrifft weiter ein Herstellungsverfahren für solche Sensorelemente.

Die WO 2009/056299 A1 offenbart einen gattungsgemäßen Biosensor mit verschiedenen Strukturbereichen, in denen das Flächenmuster der Schichtstruktur aus verschiedenen elektrisch leitenden Metallen gebildet ist. Beispielsweise soll ein erster Flächenbereich aus einem ersten elektrisch leitenden Material neben einem zweiten Flächenbereich aus einem zweiten elektrisch leitenden Material auf dem Substrat angeordnet sein. Die verschiedenen Bereiche können an Anschlussstellen von wenigen Millimetern Breite elektrisch leitend aneinander angeschlossen sein. Die verschiedenen Metallschichten der Schichtstruktur stehen somit alle an ihrer Unterseite in flächigem Kontakt mit der Substratoberfläche und müssen auf dieser eigens strukturiert werden. Durch die nur linienförmigen Anschlussstellen können sich variierende Übergangswiderstände ergeben.

Aus der WO 2006/018447 A2 geht ein elektrochemisches Sensorsystem mit einer sandwichartigen 3D-Elektrodenstruktur hervor. In einer Ausführungsform wird eine leitende Schicht durch Ätzen einer durchgängigen Grundschicht aus Au oder Ag oder Cu oder Al oder InSnO gebildet und im Bereich einer zu bildenden Elektrodenoberfläche mit einem Metallüberzug aus Pt oder Au oder Ag versehen. Auf diese Weise sollen bessere elektrochemische Eigenschaften der Elektrodenoberfläche erreicht werden.

Ausgehend hiervon liegt der Erfindung die Aufgabe zugrunde, die im Stand der Technik bekannten Erzeugnisse und Verfahren weiter zu verbessern und eine zuverlässige, einfach herstellbare und materialsparende Bauform für die Massenherstellung von analytischen Verbrauchsmitteln anzugeben.

Zur Lösung dieser Aufgabe wird die in den unabhängigen Patentansprüchen angegebene Merkmalskombination vorgeschlagen. Vorteilhafte Ausgestaltungen und Weiterbildungen der Erfindung ergeben sich aus den abhängigen Ansprüchen.

Die Erfindung geht von dem Gedanken aus, mehrlagige metallische Kombinationsschichten für eine elektrisch leitende Schichtstruktur einzusetzen. Dementsprechend wird erfindungsgemäß vorgeschlagen, dass die Schichtstruktur eine aus Tantal oder Niob oder einer Legierung davon bestehende durchgängige metallische Grundschicht und eine insgesamt auf der Grundschicht aufgebaute und diese vollflächig oder bereichsweise überdeckende, im Abstand zu der Substratoberfläche befindliche metallische Deckschicht aufweist, wobei die Deckschicht aus einem edlen Metall besteht. Das unedle Metall der Grundschicht bildet somit durchgängig die gesamte auf der Substratoberfläche haftende Unterseite der auf dem Substrat vorhandenen Schichtstruktur, während die Deckschicht insgesamt nicht in Kontakt mit dem Substrat kommt bzw. keinen Kontakt zu Substratoberfläche besitzt und mit reduzierter Schichtdicke und ggf. begrenzter Flächenausdehnung beispielsweise nur in funktionellen Bereichen materialsparend eingesetzt werden kann. Die unterschiedlichen Schichtmaterialien lassen sich dabei gezielt auf ihre jeweilige Funktion abstimmen, indem die durchgängige Grundschicht gut haftend, robust und elektrisch gut leitend aus relativ preiswertem unedlen Metall und die Deckschicht elektrochemisch inert und in den Oberflächeneigenschaften beständig aus Edelmetall gebildet wird. Ein weiterer besonderer Vorteil besteht darin, dass die Kombinationsschichten im Verbund gemeinsam strukturiert werden können.

Vorteilhafterweise besitzt die Grundschicht eine größere Schichtdicke als die Deckschicht, so dass das Edelmetall möglichst materialsparend eingesetzt werden kann. Dabei ist es auch möglich, die Deckschicht auf bestimmte Funktionsbereiche der Schichtstruktur zu begrenzen, wobei jedenfalls die Deckschicht mehr als 5%, vorzugsweise mehr als 10% der Gesamtfläche der Grundschicht bedeckt.

Um für den Messerfolg besonders wichtige Funktionsbereiche zu optimieren, ist es vorteilhaft, wenn die Elektrodenanordnung und gegebenenfalls ein Kontaktfeldbereich zum elektrischen Anschluss der Elektrodenanordnung zweilagig metallisch ausgebildet sind.

Für elektrochemische Testelemente ist es von besonderem Vorteil, wenn die Deckschicht aus Edelmetall, vorzugsweise Gold besteht. Grundsätzlich kommen neben Gold auch andere Edelmetalle wie Palladium, Platin oder eine Legierung davon oder damit als Material für die Deckschicht in Betracht.

Zur Reduzierung des kostenintensiven Materialeinsatzes ist es vorteilhaft, wenn die Deckschicht eine Schichtdicke von weniger als 50 nm, vorzugsweise weniger als 20 nm aufweist.

Eine bevorzugte Ausgestaltung sieht vor, dass die Grundschicht vollständig aus Tantal besteht. Tantal ist als unedles Metall bevorzugt, da es einfach zu sputtern ist und an Luft eine dünne, dichte, chemisch passive Oxidschicht bildet. Durch die passive Tantaloxidschicht wird auch vermieden, dass bei diagnostischen Sensoren unerwünschte Zusatzsignale durch elektrochemisch aktives Oberflächenverhalten auftreten. Überraschend wurde auch gefunden, dass Tantal auf den üblichen Trägersubstraten wesentlich besser haftet als Gold. Auch die Duktilität einer gesputterten Tantalschicht bleibt vergleichsweise hoch, insbesondere wenn Gasverunreinigungen durch Luft und Wasser in der Sputteranlage vermieden werden. Zudem wirft Tantal keine toxikologischen Probleme bei der Verwendung in diagnostischen Artikeln auf. Prinzipiell auch als Grundschicht geeignet sind alle Metalle, die an Luft ebenfalls eine dichte, chemisch passive Oxidschicht ausbilden. Dies sind in erster Linie Niob sowie Legierungen aus Tantal und Niob. Aus Kosten- und Verarbeitungsgründen wird jedoch allein Tantal bevorzugt.

Vorteilhafterweise besitzt die Grundschicht eine im Wesentlichen konstante Schichtdicke vorzugsweise im Bereich von 50 bis 200 nm. Eine vorteilhafte Anwendung kann auch darin bestehen, dass auf das Trägersubstrat eine Tantal-Grundschicht von geringer Schichtdicke beispielsweise von 0,5 nm bis 10 nm als Haftvermittler für eine darüberliegende Deckschicht aus Edelmetall aufgebracht wird.

Für spezifische Tests ist im Bereich der Elektrodenanordnung ein zum elektrochemischen Nachweis eines Analyten in der Probe ausgebildetes Reagenzsystem vorzugsweise schichtförmig angeordnet.

In verfahrensmäßiger Hinsicht wird zur Lösung der eingangs genannten Aufgabe vorgeschlagen, dass die Schichtstruktur aus einer durchgängigen Grundschicht aus Tantal oder Niob oder einer Legierung davon und zumindest bereichsweise aus einer auf der Grundschicht aufgebauten Deckschicht aus im Vergleich zum Metall der Grundschicht edlerem Metall gebildet wird.

Eine solche Kombinationsschicht lässt sich in einem für die Massenproduktion geeigneten Prozess dadurch fertigen, dass zunächst die Grundschicht auf dem Trägersubstrat und anschließend die Deckschicht auf der Grundschicht durch sukzessive Beschichtungsprozesse aufgebracht werden. In diesem Zusammenhang ist es besonders bevorzugt, die Grundschicht und die Deckschicht durch Sputterdeposition zu bilden.

Um eine möglichst hohe Qualität der erzeugten Schichtstruktur zu erhalten, ist es vorteilhaft, wenn die Grundschicht und die Deckschicht in einem Vakuumkessel nacheinander ohne Unterbrechung des Vakuums aufgesputtert werden.

Um Funktionsbereiche speziell auszustatten, ist es vorteilhaft, wenn die Deckschicht über eine Maske oder Blende bereichsweise, vorzugsweise streifenförmig auf die Grundschicht aufgebracht wird.

Günstig ist es auch, die Grundschicht und die Deckschicht gemeinsam durch Materialabtragung von Teilbereichen vorzugsweise durch Laserablation geometrisch zu strukturieren.

Ein weiterer Erfindungsaspekt liegt in der Verwendung einer zweilagigen Schichtstruktur bestehend aus einer Grundschicht aus Tantal oder Niob oder einer Legierung davon und einer Deckschicht aus edlerem Metall, vorzugsweise Edelmetall für die Herstellung von disposiblen elektrochemischen Sensorelementen, insbesondere Teststreifen oder Testbändern für Glukosetests. Andere Analyten, für die die zweilagige Schichtstruktur bevorzugt verwendet werden kann, sind z.B. Lactat und Gerinnungsparameter wie PT (Prothrombinzeit). Solche Tests müssen häufig wiederkehrend möglichst kostengünstig durchgeführt werden, wobei hohe Anforderungen an die Testgenauigkeit gestellt werden und durch die zu untersuchenden Körperflüssigkeiten spezielle Randbedingungen bestehen. Die gefundene Beständigkeit des erfindungsgemäßen Schichtaufbaus gegen Ablösung bei Lagerung in wässrigem Puffer belegt zudem die besondere Eignung zur Verwendung zur Herstellung von implantierbaren oder teilimplantierbaren Sensoren wie z.B. subcutanen Glukosesensoren zur kontinuierlichen Messung von Glukose im subcutanen Fettgewebe.

Im Folgenden wird die Erfindung anhand des in der Zeichnung schematisch dargestellten Ausführungsbeispiels näher erläutert. Es zeigen:
- Fig. 1: ein elektrochemisches Sensorelement mit einer bereichsweise zweilagigen metallischen Schichtstruktur in der Draufsicht;
- Fig. 2: das Sensorelement in einem nicht maßstäblichen Längsschnitt entlang der Linie 2 - 2 der Fig. 1;
- Fig. 3: eine schaubildliche Darstellung einer Sputteranlage zur Herstellung der zweilagigen Schichtstruktur;
- Fig. 4 und 5: Zyklovoltammogramme eines Vergleichsversuchs.

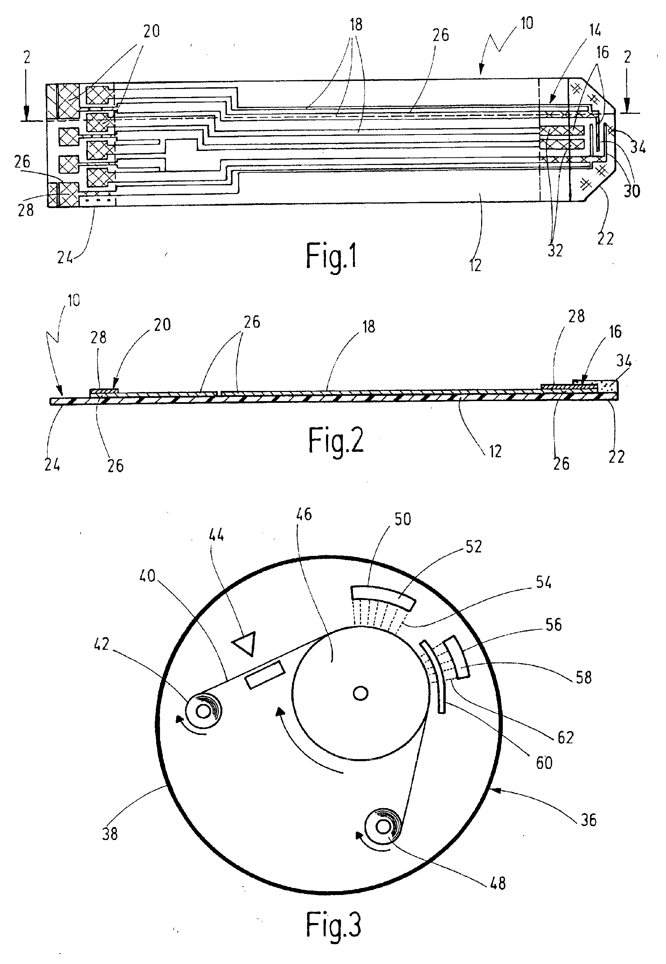

Das in Fig. 1 und 2 schematisch dargestellte Sensorelement 10 dient als Biosensor zur elektrochemischen Untersuchung von Körperflüssigkeiten und insbesondere in Form eines Teststreifens zur Glukosebestimmung in Blut und/oder Gewebeflüssigkeit. Zu diesem Zweck umfasst das Sensorelement 10 ein nichtleitendes streifenförmiges Trägersubstrat 12 und eine darauf aufgebrachte, elektrisch leitende Schichtstruktur 14, die eine mit der Flüssigprobe beaufschlagbare Elektrodenanordnung 16, elektrische Leiterbahnen 18 und Kontaktfelder 20 am Anschlussende der Leiterbahnen 18 aufweist. In den Endabschnitten 22, 24, die in Fig. 1 durch gestrichelte Linien begrenzt sind, ist die Schichtstruktur 14 aus einer dickeren Grundschicht 26 aus Tantal als unedlem Metall und einer dünneren Deckschicht 28 aus Edelmetall ausgebildet. Hingegen bestehen die Leiterbahnen 18 zwischen den Endabschnitten 22, 24 einlagig nur aus der Grundschicht 26. Die Grundschicht 26 bildet somit durchgängig die gesamte Basis der Schichtstruktur 14.

Wie in Fig. 1 gezeigt, weist die Elektrodenanordnung 16 zwei Messelektroden 30 und zwei Kontrollelektroden 32 auf. Ein trockenchemisches Reagenzsystem 34, das im Bereich zumindest einer der Messelektroden 30 aufgebracht ist, lässt sich mit der Flüssigprobe aufquellen oder lösen, um bei Anlegen einer Spannung zwischen den Messelektroden 30 einen Analyten in der Probe elektrochemisch nachweisen zu können.

Aus Fig. 2 ist deutlich ersichtlich, dass die Elektrodenanordnung 16 in dem eine Messzone bildenden Endabschnitt 22 und die Kontaktfelder 20 in dem geräteseitig anschließbaren Endabschnitt 24 insgesamt zweilagig aus der Grund- und Deckschicht 26, 28 ausgebildet sind und durch einlagige Leiterbahnen 18 in der Grundschicht 26 verbunden sind. Die Grundschicht 26 steht an ihrer Unterseite vollflächig in festhaftendem Kontakt mit der Substratoberfläche, während die Deckschicht 28 insgesamt auf der von dem Trägersubstrat abgewandten Oberseite der Grundschicht 26 aufgebaut ist und keinen Kontakt zur Substratoberfläche hat.

Zweckmäßig besteht die relativ zur Deckschicht 28 dickere Grundschicht 26 aus einem elektrisch gut leitenden, aber im Vergleich zur Deckschicht 28 unedlen und daher relativ preiswerten Metall. Hierfür eignen sich besonders Tantal, Niob oder Legierungen davon. Eine hinreichend robuste Grundschicht kann eine Schichtdicke beispielsweise von 50 nm besitzen.

Die dünnere Deckschicht 28 sollte gegen Probeneinfluss unempfindlich sein und einen möglichst konstanten Kontaktwiderstand und konstantes elektrochemisches Potential auch über längere Lagerzeiten bieten. Hierfür eignen sich besonders Edelmetalle, besonders bevorzugt Gold, geeignet sind aber auch Palladium, Platin oder Legierungen aus oder mit diesen Beschichtungsstoffen. Um Materialkosten zu minimieren, sollte die Deckschicht 28 möglichst dünn sein und beispielsweise eine Schichtdicke von weniger als 20 nm aufweisen.

Das Trägersubstrat 12 kann als Zuschnitt aus einem Kunststoff-Folienmaterial gebildet sein, so dass es sich in einer Massenproduktion einfach verarbeiten lässt und für den Gebrauchszweck hinreichend stabil ist. Das Reagenzsystem 34 kann aus einer Enzymzusammensetzung gebildet sein, die als pastöse Masse auf die Messzone 22 aufgebracht und unter Bildung einer Trockenchemieschicht getrocknet wird. Einzelheiten solcher elektrochemisch-enzymatischer Biosensoren sind dem Fachmann an sich bekannt und brauchen hier nicht näher erläutert zu werden.

Bei dem vorgesehenen Einmalgebrauch wird von einem Benutzer eine Blutprobe auf die Elektrodenanordnung 16 appliziert und sodann der Teststreifen 10 in einem nicht gezeigten Handgerät ausgewertet. Das Gerät legt über die Kontaktfelder 20 ein elektrisches Potential an die Elektrodenanordnung 16 an und erfasst eine Antwort (z.B. Strom, Impedanz, Ladung, etc.), die von der Gegenwart oder Konzentration eines Analyten, speziell Blutglukose abhängt. Nach Gebrauch wird der Teststreifen 10 entsorgt.

Fig. 3 veranschaulicht eine beispielhafte Methode zur Massenherstellung von Substraten 12 mit einer zweilagigen metallischen Schichtstruktur 14 in einer Sputteranlage 36. In einem Vakuumkessel 38 der Sputteranlage 36 wird ein Trägerfolienband 40 von einer Vorratsrolle 42 abgezogen, an einer Corona-Station 44 zur Oberflächenbehandlung vorbeigezogen und über eine Beschichtungswalze 46 auf eine Produktrolle 48 umgelenkt und dort wieder aufgewickelt.

Im Bereich der Beschichtungswalze 46 wird an einer ersten Sputterstation 50 die Grundschicht 26 vollflächig aufgebracht. Zu diesem Zweck wird von zum Beispiel einem Tantaltarget 52 durch Ionenbeschuss das Targetmaterial abgetragen und die gesputterten Teilchen 54 auf der Folienoberfläche kondensiert, wobei die Grundschicht 26 gebildet wird. Im Zuge des weiteren Bandtransports wird an einer zweiten Sputterstation 56 zum Beispiel ein Goldtarget 58 zerstäubt, um die Deckschicht 28 über der Grundschicht 26 aufzubauen. Für eine bereichsweise Begrenzung der Deckschicht 28 wird eine wassergekühlte Blende 60 eingesetzt, durch deren Öffnungen hindurch das abgesputterte Gold 62 nur in streifenförmigen Bereichen auf die Grundschicht 26 niederschlagen wird. Auf der Blende 60 scheidet sich das nicht benötigte Edelmetall ab und kann leicht wieder zurück gewonnen werden. Zur Vermeidung der Bildung von störenden Oxiden auf der Grundschicht 26 wird die Deckschicht 28 ohne Unterbruch des Vakuums und unter Ausschluss von Stickstoff, Sauerstoff, Wasserstoff und Wasserdampf unmittelbar nach der Abscheidung der Grundschicht 26 auf dieser abgeschieden; d.h., abhängig von der Transportgeschwindigkeit der Trägerfolie 40, innerhalb von Sekunden oder Sekundenbruchteilen.

Die aus dem Vakuumkessel 38 entnommene Produktrolle 48 wird in einer weiteren Verfahrensstufe durch eine Laserstation hindurchgespult, um das geometrische Flächenmuster der Schichtstruktur 14 durch Laserablation zu bilden. Dabei wird Laserlicht auf Abschnitte des Bandmaterials 40 durch eine Maske hindurch flächig eingestrahlt und dadurch das Schichtmaterial außerhalb der gewünschten Schichtstruktur 14 abgetragen. Diese Technik ist an sich bekannt und beispielsweise in der WO-A 2009/056299 beschrieben.

Die Laserablation ist effektiv und kostengünstig und verursacht einen wesentlichen geringeren Aufwand als Ätzen, was insbesondere bei MassenProdukten wichtig ist. Der Laserpuls bei der Ablation führt zu einer Metalldampfwolke, die möglichst vollständig abgesaugt werden muss. Dennoch ist es in der Praxis unvermeidbar, dass sich Metallteilchen auf dem Substrat und den Elektrodenflächen niederschlagen. Hierbei ist zu berücksichtigen, dass die Maske in relativ großer Entfernung angeordnet ist und keine Abdeckung ermöglicht. Bei Gold ist dieser Effekt harmlos, da ohnehin Goldelektroden eingesetzt werden, während bei anderen Metallen der Niederschlag in der Regel elektrochemisch aktiv ist, wenn unedle Elemente wie z.B. Kupfer enthalten sind. Jedoch bleibt Tantal überraschend stabil durch eine dichte Metalloxidoberfläche. Dabei ist auch zu berücksichtigen, dass die Laserablation an Luft erfolgt, in der Sauerstoff zur Verfügung steht. Die Oberfläche der Ablationspartikel ist daher immer oxidbedeckt, so dass sich kaum Auswirkungen bei Niederschlag auf den Elektroden ergeben und vergleichbare Ergebnisse wie mit reinem Gold erzielt werden.

In einer an die Laserablation anschließenden Fertigungsstufe kann das Bandmaterial 40 mit dem Reagenzsystem 34 versehen und in Einzelstreifen 10 zerteilt werden.

Eine auf diese Weise erzeugte Schichtstruktur 14 besitzt beispielsweise eine Grundschicht aus Tantal von circa 50 bis 70 nm Dicke, bedeckt mit einer Deckschicht aus Gold von 10 nm Dicke. Im Bereich der Leiterbahnen 18, in denen Tantal blank zu liegen kommt, bildet sich durch Einwirkung von Luftsauerstoff eine chemisch passive, nicht leitende Tantaloxidschicht. Durch die kurzfristig sehr hohe Temperatur bei der Laserablation wird die Oxidation von Tantal noch beschleunigt, so dass die Oxidschicht an verbleibenden Kanten und an gebildetem Tantalstaub dick genug ausgebildet wird, um chemisch völlig passiv zu sein. Bei der Laserablation gebildeter Goldstaub ist ohnehin inert.

Die Schichtdicke der Grundschicht 26 richtet sich zunächst nach den gewünschten elektrischen Eigenschaften, d.h. ausreichende Leitfähigkeit. Andererseits sollte sie für die Ablation nicht zu dick sein, so dass ein Kompromiss gefunden werden muss. Zu berücksichtigen ist auch, dass bei dickeren Schichten die Bruchempfindlichkeit steigt. Eine weitere Randbedingung sind die Materialkosten. Tantal ist derzeit immer noch zwei Größenordnungen günstiger als Gold, das einen wesentlichen Kostenanteil an herkömmlichen disposiblen Testelementen verursacht. Bei Verwendung von Tantal als Grundschicht kann auch eine imperfekte dünne Goldschicht als Decklage genügen. Dies liegt darin begründet, dass Fehlstellen wie Poren oder sogenannte Pinholes nur die darunterliegende Tantaloxidschicht freilegen, die elektrochemisch weitgehend neutral ist. Durch Verdampfen, beispielsweise Elektronenstrahlverdampfung können im Vergleich zum Sputtern zwar perfektere Schichten geschaffen werden, der erforderliche Vakuumprozess ist aber aufwändiger.

Anstelle von Gold könnte auch Gold-Palladium als Edelmetall eingesetzt werden. Das hat den Vorteil, dass bereits bei geringeren Dicken eine geschlossene Schicht gebildet wird. Einfach verfügbar sind Gold-PalladiumLegierungen mit 80/20 und 60/40 %.

Wird Platin als Deckschicht auf einer Tantal-Grundschicht eingesetzt, sind besonders dünne Schichten von Edelmetall möglich. Bei 2,5 nm Platin auf 50 nm Tantal reduzieren sich die Materialkosten der Schichtstruktur pro Test gegenüber reinem Gold mit 50 nm Dicke um mehr als 90 %. Wird Palladium auf Tantal eingesetzt, profitiert man vom günstigeren Preis des Palladium und der Möglichkeit, relativ dünne Schichten zu fertigen.

### Vergleichsversuche

In einem Vergleichsversuch wurden eine reine Goldschicht und verschiedene Tantal-Gold-Schichtstrukturen auf eine Trägerfolie (Melinex ® 329 erhältlich von DuPont Teijin Films) wie oben beschrieben aufgesputtert und hinsichtlich des elektrochemischen Verhaltens und der Haftfähigkeit untersucht.

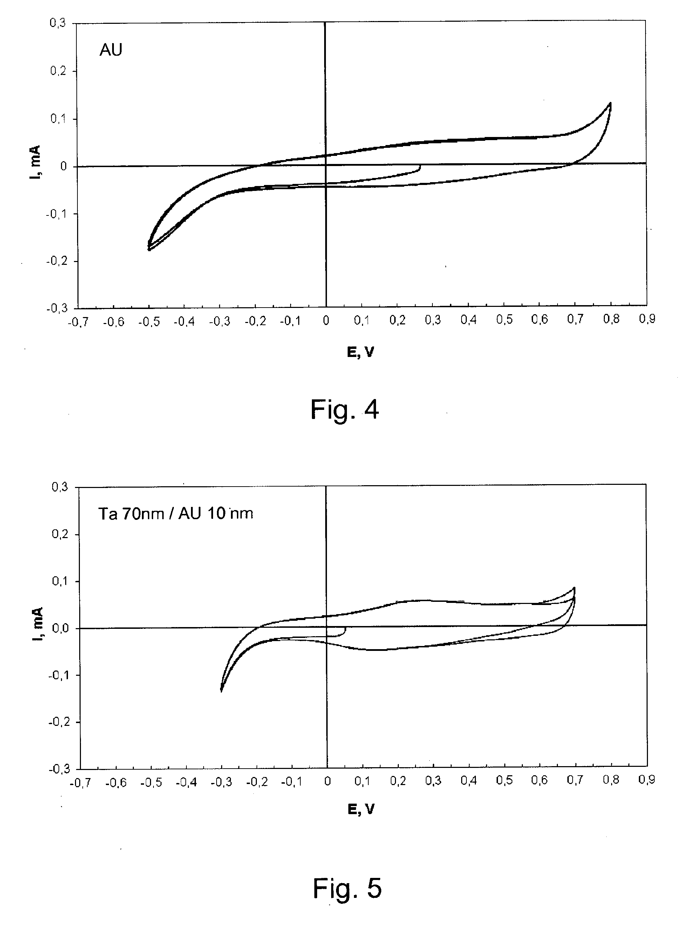

An den erzeugten Mustern wurde durch Zyklovoltammetrie in einem wässrigen Grundelektrolyt bei 22°C ein Überblick über mögliche Elektrodenprozesse gewonnen. Der Grundelektrolyt wurde aus H₂O bidest. (400 ml), KH₂PO₄ (2,07 g), K₂HPO₄ (4,86 g), NaCl 0.9% (3,6 g), Triton X100 (0,42 g) hergestellt, mit einem pH-Wert von 7.0 ± 0.1. Durch Anlegen einer sägezahnförmigen Spannung wurden die Zyklovoltammogramme gemäß Fig. 4 und 5 erhalten. Dabei wird die Stromstärke I in Abhängigkeit zum Potential E an der gebildeten Schichtelektrode für mehrere Periodendurchläufe aufgezeichnet. Fig. 4 zeigt, dass für reines Gold keine wesentlichen Elektrodenreaktionen im Bereich von -0,5 bis +0,8 Volt auftreten, die ansonsten zu einem Peak in der Strom-Potentialkurve führen würden. Auch für eine Schichtelektrode aus Grundschicht Tantal (70 nm Dicke) und Deckschicht Gold (10 nm Dicke) wurden keine störenden Elektrodenprozesse im Potentialbereich von -0,3 bis +0,7 Volt gefunden. Dabei ist zu berücksichtigen, dass übliche Messspannungen für elektrochemische Sensorelemente in diesem Bereich beispielsweise bei 0,35 Volt liegen. Zu bemerken ist auch, dass eine Goldschicht von nur 10 nm Dicke keine perfekte Oberfläche ausbildet, und dass dennoch eine solche Tantal-Gold-Elektrode keine störenden elektroaktiven Signale abgibt.

Hinsichtlich der Haftung auf dem Substrat wurde gefunden, dass eine Goldschicht von 50 nm Dicke sich nach 72 Stunden Lagerung in Pufferlösung (Grundelektrolyt nach vorstehender Rezeptur) bei Raumtemperatur mit einem saugfähigen Papier per Daumendruck mit wenig Mühe vollständig abreiben ließ. Hingegen ließ sich unter denselben Bedingungen eine Beschichtung bestehend aus einer Grundschicht von 50 nm Ta und einer Deckschicht von 30 nm Au ebenso wenig abreiben wie eine Beschichtung bestehend aus einer Grundschicht von 70 nm Ta und einer Deckschicht von 10 nm Au. Die Haftung einer Tantal-Gold-Kombinationsschicht auf dem bevorzugten Substrat Melinex 329 ist somit überraschenderweise wesentlich besser als die von reinem Gold.

Die verbesserte Haftung im Vergleich mit Gold wurde auch bei der Laserablation beobachtet. Während sich bei einer Beschichtung mit 50 nm Gold die Ränder der auf dem Substrat verbleibenden Schicht bis einige µm weit von der Kante vom Substrat abheben und aufwölben wurde derartiges an einer Beschichtung bestehend aus einer Grundschicht von 50 nm Ta und einer Deckschicht von 30 nm Au nicht beobachtet.

## Patentansprüche

1. Sensorelement (10) zur elektrochemischen Untersuchung einer Probe, insbesondere einer Körperflüssigkeit, mit einem elektrisch isolierenden Trägersubstrat (12) und einer auf der Substratoberfläche aufgebrachten, elektrisch leitenden Schichtstruktur (14), die eine mit der Probe beaufschlagbare Elektrodenanordnung (16) besitzt, **dadurch gekennzeichnet,** dass die Schichtstruktur (14) eine aus Tantal oder Niob oder einer Legierung davon bestehende durchgängige Grundschicht (26) und eine auf der Grundschicht (26) aufgebaute und diese vollflächig oder bereichsweise überdeckende metallische Deckschicht (28) aufweist, wobei die Deckschicht (28) im Vergleich zur Grundschicht (26) aus edlerem Metall besteht.

2. Sensorelement (10) nach Anspruch 1, **dadurch gekennzeichnet,** dass die Grundschicht (26) eine größere Schichtdicke als die Deckschicht (28) aufweist.

3. Sensorelement (10) nach einem der Ansprüche 1 oder 2, **dadurch gekennzeichnet,** dass die Elektrodenanordnung (16) und gegebenenfalls ein Kontaktfeldbereich (20) zum elektrischen Anschluss der Elektrodenanordnung (16) zweilagig metallisch ausgebildet ist.

4. Sensorelement (10) nach einem der Ansprüche 1 bis 3, **dadurch gekennzeichnet,** dass die Deckschicht (28) aus Edelmetall, vorzugsweise Gold, besteht.

5. Sensorelement (10) nach einem der Ansprüche 1 bis 4, **dadurch gekennzeichnet,** dass die Deckschicht (28) eine Schichtdicke von weniger als 50 nm, vorzugsweise weniger als 20 nm aufweist.

6. Sensorelement (10) nach einem der Ansprüche 1 bis 5, **dadurch gekennzeichnet,** dass die Grundschicht (26) eine im Wesentlichen konstante Schichtdicke vorzugsweise im Bereich von 50 bis 200 nm aufweist.

7. Sensorelement (10) nach einem der Ansprüche 1 bis 6, **dadurch gekennzeichnet,** dass die Grundschicht (26) als Haftvermittler für die Deckschicht (28) eine Schichtdicke von mindestens 0,5 nm und weniger als 20 nm aufweist.

8. Sensorelement (10) nach einem der Ansprüche 1 bis 7, **dadurch gekennzeichnet,** dass im Bereich der Elektrodenanordnung (16) ein zum elektrochemischen Nachweis eines Analyten in der Probe ausgebildetes Reagenzsystem (34) angeordnet ist.

9. Verfahren zur Herstellung eines elektrochemischen Sensorelements (10) nach einem der vorhergehenden Ansprüche bei welchem eine elektrisch leitende Schichtstruktur (14) auf einem elektrisch isolierenden Trägersubstrat (12) aufgebracht wird, **dadurch gekennzeichnet,** dass die Schichtstruktur (14) aus einer durchgängigen Grundschicht (26) aus Tantal oder Niob oder einer Legierung davon und zumindest bereichsweise aus einer auf der Grundschicht (26) aufgebauten Deckschicht (28) aus im Vergleich zum Metall der Grundschicht edlerem Metall gebildet wird.

10. Verfahren nach Anspruch 9, **dadurch gekennzeichnet,** dass zunächst die Grundschicht (26) auf dem Trägersubstrat (12) und anschließend die Deckschicht (28) auf der Grundschicht (26) jeweils durch einen Beschichtungsprozess aufgebracht werden.

11. Verfahren nach Anspruch 9 oder 10, **dadurch gekennzeichnet,** dass die Grundschicht (26) und die Deckschicht (28) durch Sputterdeposition gebildet werden.

12. Verfahren nach einem der Ansprüche 9 bis 11, **dadurch gekennzeichnet,** dass die Grundschicht (26) und die Deckschicht (28) in einem Vakuumkessel (38) nacheinander ohne Unterbrechung des Vakuums aufgesputtert werden.

13. Verfahren nach einem der Ansprüche 9 bis 12, **dadurch gekennzeichnet,** dass die Deckschicht (28) über eine Maske oder Blende (60) bereichsweise, vorzugsweise streifenförmig auf die Grundschicht (26) aufgebracht wird.

14. Verfahren nach einem der Ansprüche 9 bis 13, **dadurch gekennzeichnet,** dass die Grundschicht (26) und die Deckschicht (28) durch Materialabtragung von Teilbereichen vorzugsweise durch Laserablation geometrisch strukturiert werden.

15. Verwendung einer zweilagigen Schichtstruktur (14) bestehend aus einer Grundschicht (26) aus Tantal oder Niob oder einer Legierung davon und einer Deckschicht (28) aus im Vergleich zur Grundschicht (26) edlerem Metall für die Herstellung von disposiblen elektrochemischen Sensorelementen (10), insbesondere Teststreifen oder Testbändern für Glukose-, Lactat- oder PT-Tests.

## Claims

1. Sensor element (10) for the electrochemical analysis of a sample, in particular a body fluid comprising an electrically insulating carrier substrate (12) and an electrically conductive layer structure (14) deposited on the substrate surface, said layer structure having an electrode arrangement (16) to which sample can be applied, **characterized in that** the layer structure (14) has a continuous base layer (26) which consists of tantalum or niobium or an alloy thereof, and a metallic cover layer (28) which is formed on the base layer (26) and covers the said base layer either over the entire surface or in some regions thereof, wherein the cover layer (28) consists of a more noble metal compared to the base layer (26).

2. Sensor element (10) according to claim 1, **characterized in that** the base layer (26) has a larger layer thickness than the cover layer (28).

3. Sensor element (10) according to one of the claims 1 or 2, **characterized in that** the electrode arrangement (16) and where appropriate a region of contact (20) for the electrical connection of the electrode arrangement (16) are formed from metals in two layers.

4. Sensor element (10) according to one of the claims 1 to 3, **characterized in that** the cover layer (28) consists of a noble metal, preferably of gold.

5. Sensor element (10) according to one of the claims 1 to 4, **characterized in that** the cover layer (28) has a layer thickness of less than 50 nm, preferably less than 20 nm.

6. Sensor element (10) according to one of the claims 1 to 5, **characterized in that** the base layer (26) has an essentially constant layer thickness preferably in the range of 50 to 200 nm.

7. Sensor element (10) according to one of the claims 1 to 6, **characterized in that** the base layer (26) as a bonding agent for the cover layer (28) has a layer thickness of at least 0.5 nm and less than 20 nm.

8. Sensor element (10) according to one of the claims 1 to 7, **characterized in that** a reagent system (34) designed for the electrochemical detection of an analyte in the sample is arranged in the region of the electrode arrangement (16).

9. Process for producing an electrochemical sensor element (10) according to one of the previous claims in which an electrically conducting layer structure (14) is deposited on an electrically insulating carrier substrate (12), **characterized in that** the layer structure (14) is formed from a continuous base layer (26) made of tantalum or niobium or an alloy thereof and at least in some areas of a cover layer (28) formed on the base layer (26) which cover layer is made of a more noble metal compared to the metal of the base layer.

10. Process according to claim 9, **characterized in that** firstly the base layer (26) is applied to the carrier substrate (12) and subsequently the cover layer (28) is applied to the base layer (26) in each case by a coating process.

11. Process according to claim 9 or 10, **characterized in that** the base layer (26) and the cover layer (28) are formed by sputter deposition.

12. Process according to one of the claims 9 to 11, **characterized in that** the base layer (26) and the cover layer (28) are successively sputtered on in a vacuum chamber (38) without interrupting the vacuum.

13. Process according to one of the claims 9 to 12, **characterized in that** the cover layer (28) is applied sectionally to the base layer (26) through a mask or aperture (60), preferably in a strip shape.

14. Process according to one of the claims 9 to 13, **characterized in that** the base layer (26) and the cover layer (28) are geometrically structured by removing material from sections preferably by laser ablation.

15. Use of a two-layered layer structure (14) consisting of a base layer (26) made of tantalum or niobium or an alloy thereof and a cover layer (28) made of a more noble metal compared to the base layer (26) for the production of disposable electrochemical sensor elements (10), in particular test strips or test tapes for glucose, lactate or PT tests.

## Revendications

1. Elément capteur (10) pour l'examen électrochimique d'un échantillon, en particulier d'un liquide corporel, avec un substrat de support électriquement isolant (12) et une structure de couches électriquement conductrice (14) déposée sur la surface du substrat, qui comporte un dispositif d'électrodes (16) pouvant être exposé à l'échantillon, **caractérisé en ce que** la structure de couches (14) présente une couche de base continue (26) composée de tantale ou de niobium ou d'un alliage de ceux-ci et une couche de recouvrement métallique (28) formée sur la couche de base (26) et recouvrant entièrement ou localement celle-ci, dans lequel la couche de recouvrement (28) se compose d'un métal plus noble que la couche de base (26).

2. Elément capteur (10) selon la revendication 1, **caractérisé en ce que** la couche de base (26) présente une plus grande épaisseur de couche que la couche de recouvrement (28).

3. Elément capteur (10) selon l'une des revendications 1 ou 2, **caractérisé en ce que** le dispositif d'électrodes (16) et éventuellement une zone de contact (20) pour le raccordement électrique du dispositif d'électrodes (16) est réalisé sous forme métallique à deux couches.

4. Elément capteur (10) selon l'une quelconque des revendications 1 à 3, **caractérisé en ce que** la couche de recouvrement (28) se compose de métal noble, de préférence d'or.

5. Elément capteur (10) selon l'une quelconque des revendications 1 à 4, **caractérisé en ce que** la couche de recouvrement (28) présente une épaisseur de couche de moins de 50 nm, de préférence de moins de 20 nm.

6. Elément capteur (10) selon l'une quelconque des revendications 1 à 5, **caractérisé en ce que** la couche de base (26) présente une épaisseur de couche essentiellement constante, de préférence comprise dans la plage de 50 à 200 nm.

7. Elément capteur (10) selon l'une quelconque des revendications 1 à 6, **caractérisé en ce que** la couche de base (26) présente, comme agent adhésif pour la couche de recouvrement (28), une épaisseur de couche d'au moins 0,5 nm et de moins de 20 nm.

8. Elément capteur (10) selon l'une quelconque des revendications 1 à 7, **caractérisé en ce qu'**un système de réactif (34) conçu pour la recherche électrochimique d'un analyte dans l'échantillon est disposé dans la région du dispositif d'électrodes (16).

9. Procédé de fabrication d'un élément capteur électrochimique (10) selon l'une quelconque des revendications précédentes, dans lequel on dépose une structure de couches électriquement conductrice (14) sur un substrat de support électriquement isolant (12), **caractérisé en ce que** l'on forme la structure de couches (14) avec une couche de base continue (26) en tantale ou en niobium ou en un alliage de ceux-ci et au moins localement avec une couche de recouvrement (28), construite sur la couche de base (26), en un métal plus noble par comparaison avec le métal de la couche de base.

10. Procédé selon la revendication 9, caractérisé en ce l'on dépose d'abord la couche de base (26) sur le substrat de support (12) et ensuite la couche de recouvrement (28) sur la couche de base (26) chaque fois par un procédé de revêtement.

11. Procédé selon la revendication 9 ou 10, **caractérisé en ce que** l'on forme la couche de base (26) et la couche de recouvrement (28) par dépôt par pulvérisation cathodique.

12. Procédé selon l'une quelconque des revendications 9 à 11, **caractérisé en ce que** l'on dépose par pulvérisation cathodique la couche de base (26) et la couche de recouvrement (28) l'une après l'autre dans une enceinte sous vide (38) sans interruption du vide.

13. Procédé selon l'une quelconque des revendications 9 à 12, **caractérisé en ce que** l'on dépose la couche de recouvrement (28) au moyen d'un masque ou d'un écran (60) localement, de préférence en forme de ruban sur la couche de base (26).

14. Procédé selon l'une quelconque des revendications 9 à 13, **caractérisé en ce que** l'on confère une structure géométrique à la couche de base (26) et à la couche de recouvrement (28) par enlèvement de métal dans des zones partielles, de préférence par ablation au laser.

15. Utilisation d'une structure de couches (14) à deux couches, composée d'une couche de base (26) en tantale ou en niobium ou en un alliage de ceux-ci et d'une couche de recouvrement (28) en un métal plus noble que la couche de base (26) pour la fabrication d'éléments capteurs électrochimiques jetables (10), en particulier de rubans de test ou de bandes de test pour des tests du glucose, du lactate ou PT.
